(19) Europäisches Patentamt
European Patent Office
Office européen des brevets

(11) **EP 4 730 658 A1**

(12) **EUROPEAN PATENT APPLICATION**
published in accordance with Art. 153(4) EPC

(43) Date of publication:
**22.04.2026 Bulletin 2026/17**

(21) Application number: **24825776.8**

(22) Date of filing: **10.06.2024**

(51) International Patent Classification (IPC):
$H03M\ 1/12^{(2006.01)}$    $G01R\ 31/388^{(2019.01)}$
$H01M\ 10/48^{(2006.01)}$    $H02J\ 7/00^{(2026.01)}$
$H02J\ 7/04^{(2006.01)}$    $H02J\ 7/10^{(2006.01)}$

(52) Cooperative Patent Classification (CPC):
Y02E 60/10

(86) International application number:
**PCT/JP2024/021023**

(87) International publication number:
**WO 2024/262371 (26.12.2024 Gazette 2024/52)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **19.06.2023 JP 2023099984**

(71) Applicant: **Kabushiki Kaisha Toyota Chuo
Kenkyusho
Nagakute-shi, Aichi 480-1192 (JP)**

(72) Inventors:
• **ISHIKAWA, Keisuke**
 **Nagakute-shi, Aichi 480-1192 (JP)**
• **ISHIGAKI, Masanori**
 **Nagakute-shi, Aichi 480-1192 (JP)**

(74) Representative: **Kramer Barske Schmidtchen
Patentanwälte PartG mbB
European Patent Attorneys
Landsberger Strasse 300
80687 München (DE)**

(54) **PEAK HOLD DEVICE, IMPEDANCE MEASUREMENT DEVICE, METAL DEPOSITION DETECTION DEVICE, AND BATTERY INTERNAL TEMPERATURE ESTIMATION DEVICE**

(57)    Provided is a peak hold device 100 that uses a maximum peak or a minimum peak as a target peak from which to acquire a peak value, and for a plurality of damped oscillation waveforms, repeats a process of starting to hold a damped oscillation waveform value at a time before the target peak, and ceasing to hold the damped oscillation waveform value at a time after the target peak.

FIG. 1

**Description**

TECHNICAL FIELD

The present disclosure relates to a peak hold device, an impedance measurement device, a metal deposition detection device, and a battery internal temperature estimation device.

BACKGROUND

Disclosed is a peak hold circuit including a switch being turned on when an output voltage is increased and turned off when the output voltage is held, a capacitor accumulating charge when the output voltage is increased and holding the charge when the output voltage is held, a reset switch initializing the capacitor by discharging the charge accumulated in the capacitor by a reset signal, a voltage comparator outputting a voltage that turns the switch on when an input signal is equal to or greater than a reference voltage and outputting a voltage that turns the switch off when the input voltage is less than the reference voltage, and a voltage attenuation circuit damping the output voltage and outputting the damped voltage as the reference voltage for the voltage comparator.

SUMMARY

In the peak hold circuit of the related art, a targeted peak waveform is a single instantaneous pulse peak or obtained peak values of identical pulse waveforms that are input continuously. Due to speed performance bottleneck of the circuit, the peak value of a single pulse can be accurately acquired at low frequencies, but difficulty is encountered in accurately acquiring the peak value of the single pulse at high frequencies. In contrast, when obtaining continuous pulses, a voltage value corresponding to the charge held in the capacitor gradually follows the peak value, and the peak value can be accurately acquired even at high frequencies. Meanwhile, there is a problem that it is necessary to integrate the charge a plurality of cycles to follow the peak value and acquire an accurate peak value, thereby increasing a measurement time. By reducing charge hold capacitance, it is possible to follow the peak value with fewer cycles, but there is a problem that voltage drop due to leakage current increases and accuracy of the peak value decreases.

An aspect of the present disclosure relates to a peak hold device, in which the peak hold device acquires a peak value of any maximum peak or minimum peak included in a damped oscillation waveform, and the peak hold device uses the maximum peak or the minimum peak as a target peak from which to acquire the peak value, and for a plurality of damped oscillation waveforms, repeats a process of starting to hold a damped oscillation waveform value at a time before the target peak, and ceasing to hold the damped oscillation waveform value at a time after the target peak.

Here, it is preferable that, after starting to hold the damped oscillation waveform value at the time before the target peak, a value of a damped oscillation waveform including a maximum peak or a minimum peak other than the target peak is held.

It is preferable that the peak hold device further includes a peak hold circuit including a charging circuit including a capacitor, a switch for starting or ceasing charging of the capacitor, and a comparator, in which the comparator compares an output voltage value of the peak hold circuit with a voltage value of the damped oscillation waveform and outputs a comparison result, and the switch is turned on according to the comparison result to start charging of the capacitor at the time before the target peak, and the switch is turned off according to the comparison result to cease charging of the capacitor at the time after the target peak.

It is preferable that the charging circuit includes a resistor between a charging part supplying power to the capacitor and the capacitor.

It is preferable that the resistor is a variable resistor, and charging of the capacitor is controlled by changing a resistance value of the variable resistor in response to a change in the output voltage of the peak hold circuit.

Another aspect of the present disclosure relates to an impedance measurement device measuring a real impedance and an imaginary impedance of the battery using the peak value acquired by the peak hold device.

Another aspect of the present disclosure relates to a metal deposition detection device estimating a deposition amount of metal in a lithium-ion battery from a decrease in the real impedance measured by the impedance measurement device.

Another aspect of the present disclosure relates to a battery internal temperature estimation device estimating an internal temperature of the battery from a change amount of at least one of the real impedance and the imaginary impedance measured by the impedance measurement device.

According to the present disclosure, a peak hold device capable of acquiring any peak value of a damped oscillation waveform more quickly can be provided, and an impedance measurement device, a metal deposition detection device, and a battery internal temperature estimation device using the peak hold device can be provided.

BRIEF DESCRIPTION OF DRAWINGS

An embodiment of the present disclosure will be described based on the following figures, wherein:

[FIG. 1] FIG. 1 is a diagram illustrating a configuration of a peak hold device in an embodiment of the present disclosure;

[FIG. 2] FIG. 2 is a flowchart illustrating a peak hold process in the embodiment of the present disclosure;

[FIG. 3] FIG. 3 is a diagram illustrating a sequence of the peak hold process in the embodiment of the present disclosure;

[FIG. 4] FIG. 4 is a diagram illustrating an example of a temporal change in a damped oscillation waveform of a resonance voltage in the embodiment of the present disclosure;

[FIG. 5] FIG. 5 is a diagram illustrating an example of a peak hold circuit in the embodiment of the present disclosure;

[FIG. 6] FIG. 6 is a diagram illustrating an example of the peak hold circuit in the embodiment of the present disclosure;

[FIG. 7] FIG. 7 is a diagram illustrating an example of the peak hold circuit in the embodiment of the present disclosure;

[FIG. 8] FIG. 8 is a diagram illustrating an example of the peak hold circuit in the embodiment of the present disclosure;

[FIG. 9] FIG. 9 is a diagram illustrating a relationship between an impedance and a deposition amount of lithium in a battery in the embodiment of the present disclosure; and

[FIG. 10] FIG. 10 is a diagram illustrating a relationship between the impedance and an internal temperature of the battery in the embodiment of the present disclosure.

DESCRIPTION OF EMBODIMENTS

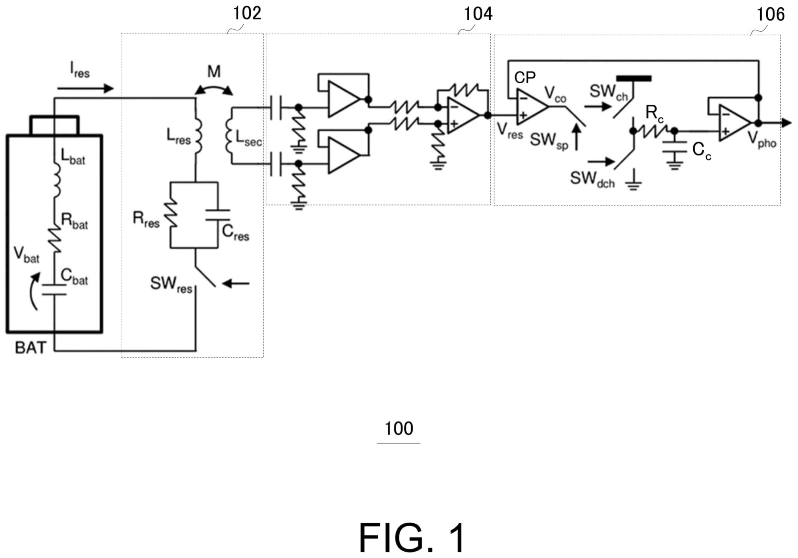

In an embodiment of the present disclosure, a peak hold device 100 includes a resonance circuit 102, a differential single conversion circuit 104, and a peak hold circuit 106 as illustrated in FIG. 1. The peak hold device 100 is connected to a battery BAT and acquires, holds, and outputs a peak voltage value of any maximum peak or minimum peak included in a signal having a damped oscillation waveform generated by the resonance circuit 102.

The resonance circuit 102 is connected to the battery BAT, converts a voltage of the battery BAT into a resonance voltage having a damped oscillation waveform by controlling a timing of opening and closing a switch $SW_{res}$, and outputs the converted voltage. The resonance circuit 102 includes resonance inductors $L_{res}$ and $L_{sec}$, a resonance capacitor $C_{res}$, and a resonance resistor $R_{res}$. The resonance inductor $L_{res}$ and the resonance inductor $L_{sec}$ have a transformer structure having a mutual inductor M.

The differential single conversion circuit 104 differentially amplifies a resonance voltage $V_{res}$ generated in the resonance inductor $L_{sec}$ and outputs the result to the peak hold circuit 106.

The peak hold circuit 106 is a non-inverting type peak hold circuit including a comparator CP. An output voltage value (peak hold voltage value) $V_{pho}$ acquired and held by the peak hold circuit 106 is input to an inverting input terminal of the comparator CP, and the resonance voltage $V_{res}$ output from the differential single conversion circuit 104 is input to a non-inverting input terminal of the comparator CP. The comparator CP generates a pulse signal $V_{co}$ when the resonance voltage $V_{res}$ is greater than the output voltage value $V_{pho}$, and turns on a switch $SW_{ch}$ when a switch $SW_{sp}$ is in an on state. Meanwhile, a pulse signal is not generated when the resonance voltage $V_{res}$ is lower than the output voltage value $V_{pho}$, and the switch $SW_{ch}$ is turned off even when the switch $SW_{sp}$ is in the on state. When the switch $SW_{sp}$ is in an off state, the switch $SW_{ch}$ is turned off regardless of whether the pulse signal $V_{co}$ is output from the comparator CP. When the switch $SW_{ch}$ is turned on, a current from a charging part (voltage source) supplying power to a charge capacitor $C_c$ flows to the charge capacitor $C_c$ via a resistor $R_c$, and a charge is accumulated in the charge capacitor $C_c$, thereby raising a terminal voltage of the charge capacitor $C_c$. Then, the terminal voltage of the charge capacitor $C_c$ is output as the output voltage value $V_{pho}$ of the peak hold circuit 106. A switch $SW_{dch}$ is turned on to discharge and reset the charge accumulated in the charge capacitor $C_c$.

Here, depending on a time constant of the resistor $R_c$ and the charge capacitor $C_c$, the terminal voltage of the charge capacitor $C_c$ can reach a peak voltage value of the resonance voltage $V_{res}$ input in a single charging operation. However, when a frequency of the resonance voltage $V_{res}$ is high, an error between the resonance voltage $V_{res}$ and the output voltage value $V_{pho}$ of the peak hold circuit 106 increases due to influence from switching delay or feedback delay. Accordingly, it is preferable to set the time constant of the resistor $R_c$ and the charge capacitor $C_c$ to a value at which the terminal voltage of the charge capacitor $C_c$ does not reach the peak voltage value of the resonance voltage $V_{res}$ in a single operation. By providing the resistor $R_c$, the lower the terminal voltage of the charge capacitor $C_c$, the faster the charging of the electric charge, and the higher the terminal voltage, the slower the charging of the electric charge, so that it is possible to acquire and hold the peak voltage value of each peak of the resonance voltage $V_{res}$ with high accuracy.

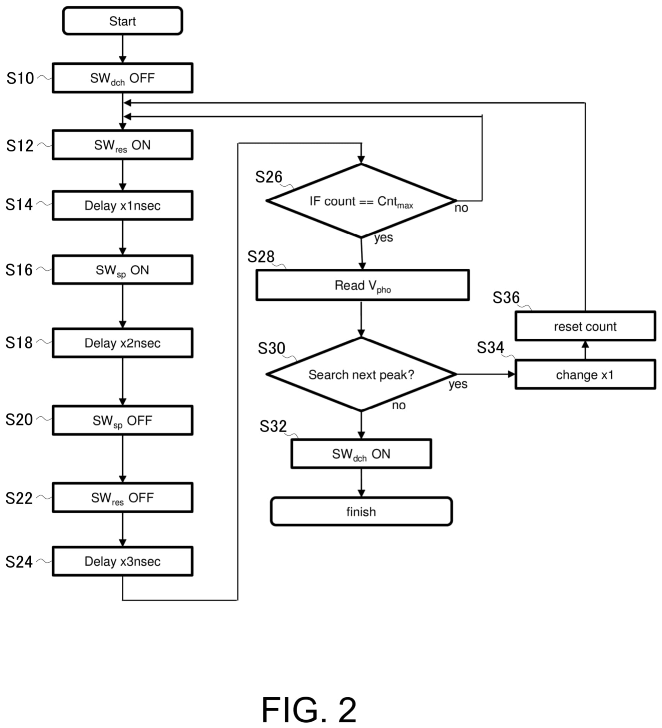

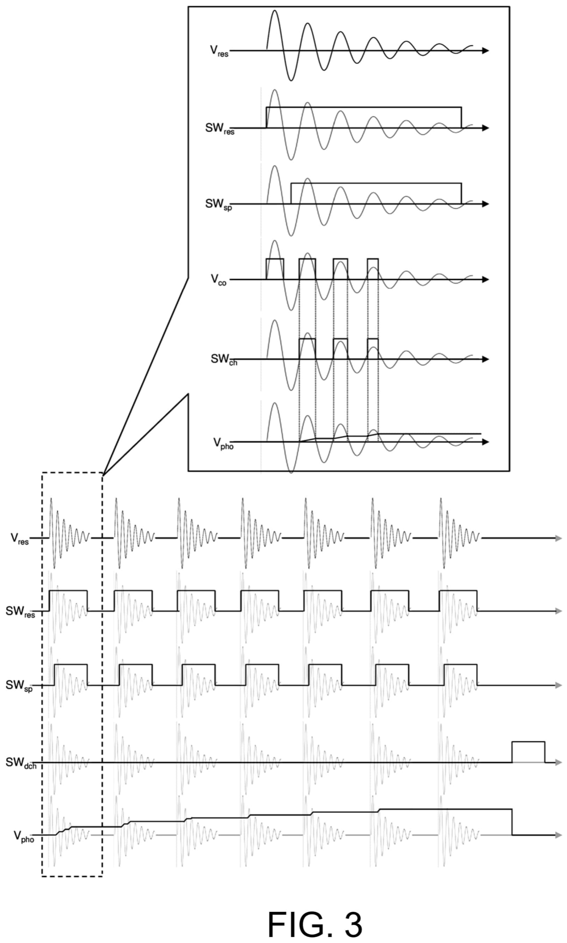

FIG. 2 is a flowchart illustrating a peak hold process of acquiring and holding a peak voltage value of the resonance voltage $V_{res}$ having the damped oscillation waveform. FIG. 3 is a diagram illustrating a sequence of the peak hold process by the peak hold device 100. FIG. 3 illustrates a sequence of peak-holding a peak voltage value of a second peak of the resonance voltage $V_{res}$ having the damped oscillation waveform as a target peak.

In step S10, the switch $SW_{dch}$ is turned off so that the charge capacitor $C_c$ transitions from a reset state in which the charge capacitor discharges the charge to a state in which the charge capacitor can accumulate charge. Here, a count value count that is the number of cycles of the process is also reset to 0.

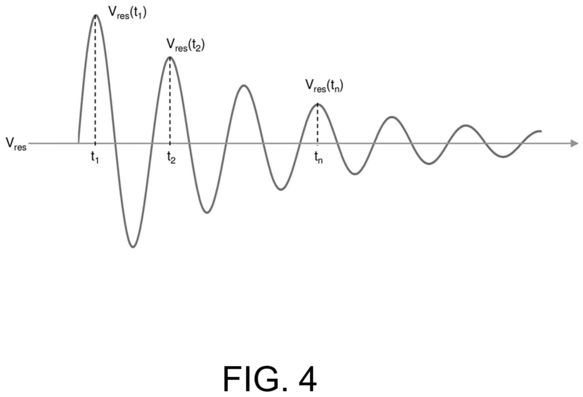

In step S12, the switch $SW_{res}$ of the resonance circuit 102 switches from off to on. As a result, the resonance voltage $V_{res}$ having the damped oscillation waveform is output from the resonance circuit 102. Here, the count value (count) for the number of cycles of the process is incremented by 1. FIG. 4 illustrates an example of a temporal change in the damped oscillation waveform of the resonance voltage $V_{res}$. With the temporal change as the horizontal axis, the resonance voltage $V_{res}$ represents a peak value $V_{res}(t_1)$ at time $t_1$, a peak value $V_{res}(t_2)$ at time $t_2$, ..., and a peak value $V_{res}(t_n)$ at elapsed time $t_n$.

In step S14, a delay process is performed for a predetermined delay time. Here, the delay time is set so that, starting from a time when the switch $SW_{res}$ is turned on, a delay occurs until a time after a peak immediately before a target peak to be peak-held and before the target peak, in the resonance voltage $V_{res}$ having the damped oscillation waveform. In particular, it is preferable to set the delay time so that the switch $SW_{sp}$ switches from off to on at a position between 1/4 of the wavelength and 3/4 of the wavelength of the target peak. For example, in FIG. 4, when the second peak of the resonance voltage $V_{res}$ having the damped oscillation waveform is used as the target peak of peak holding, based on a time when the switch $SW_{res}$ is turned on and generation of the resonance voltage $V_{res}$ having the damped oscillation waveform starts, the delay time is set from after the time $t_1$ of the first peak immediately before the target peak to before the time $t_2$ of the second peak that is the target peak.

In step S16, the switch $SW_{sp}$ switches from off to on. As a result, the switch $SW_{ch}$ is turned on by the pulse signal $V_{co}$ generated when the output voltage value $V_{pho}$ is greater than the resonance voltage $V_{res}$ in the comparator CP.

The comparator CP compares the output voltage value $V_{pho}$ input to the inverting input terminal with the resonance voltage $V_{res}$ input to the non-inverting input terminal, and when the resonance voltage $V_{res}$ is greater than the output voltage value $V_{pho}$, the pulse signal $V_{co}$ is generated so that the switch $SW_{ch}$ is turned on. Here, a current flows into the charge capacitor $C_c$ via the resistor $R_c$, a charge is accumulated in the charge capacitor $C_c$, and the terminal voltage of the charge capacitor $C_c$ and the output voltage value $V_{pho}$ rise.

As illustrated in the enlarged view of FIG. 3, since the comparator CP outputs the pulse signal $V_{co}$ when the output voltage value $V_{pho}$ is greater than the resonance voltage $V_{res}$, when the switch $SW_{sp}$ is in the on state, the charge capacitor $C_c$ is repeatedly charged with electric charge in response to each peak of the damped oscillation waveform of the resonance voltage $V_{res}$ until the output voltage value $V_{pho}$ is greater than the resonance voltage $V_{res}$. Meanwhile, the comparator CP does not generate the pulse signal when the resonance voltage $V_{res}$ is greater than the output voltage value $V_{pho}$, and charging of the charge capacitor $C_c$ with electric charge ends.

In step S18, a delay process is performed for a predetermined delay time. Here, the delay time is set so that, starting from a time when the switch $SW_{res}$ is turned on, a delay occurs after the target peak to be peak-held in the resonance voltage $V_{res}$ having the damped oscillation waveform until a time before the time when the next resonance voltage $V_{res}$ is generated. For example, in FIG. 4, when the second peak of the resonance voltage $V_{res}$ having the damped oscillation waveform is used as the target peak of peak hold, based on a time when the switch $SW_{res}$ is turned on and generation of the resonance voltage $V_{res}$ having the damped oscillation waveform starts, the delay time is set from after the time $t_2$ of the second peak that is the target peak to a time before the time when the next resonance voltage $V_{res}$ is generated.

In step S20, the switch $SW_{sp}$ switches from on to off. As a result, the pulse signal $V_{co}$ output from the comparator CP is no longer transmitted to the switch $SW_{ch}$, and the switch $SW_{ch}$ is turned off regardless of a magnitude relationship between the output voltage value $V_{pho}$ and the resonance voltage $V_{res}$.

In step S22, the switch $SW_{res}$ of the resonance circuit 102 switches from on to off. As a result, the resonance voltage $V_{res}$ having the damped oscillation waveform is no longer output from the resonance circuit 102.

In step S24, a delay process is performed for a predetermined delay time. Here, the delay time is a waiting time until the next resonance voltage $V_{res}$ having the damped oscillation waveform is generated, and it is preferable to set the time so that the previous resonance voltage $V_{res}$ is damped to a degree that does not affect the next resonance voltage $V_{res}$ having the damped oscillation waveform.

In step S26, it is determined whether the count value (count) has reached a maximum count $Cnt_{max}$. When the count value has reached the maximum count $Cnt_{max}$, the process proceeds to step S28, and when the maximum count is not reached, the process returns to step S12 and the peak hold process is repeated for the same peak. The maximum count $Cnt_{max}$ may be set in advance so that the process is repeated to a degree that ensures reliable performance of the peak hold process.

By repeating the process of steps S12 to S26, the peak hold process is performed as indicated by changes in the output voltage value $V_{pho}$ shown at the bottom of FIG. 3. In the first resonance voltage $V_{res}$, the charge capacitor $C_c$ is charged with electric charge by second, third, and fourth damped oscillation peaks, and as a result, the output voltage value $V_{pho}$ gradually rises until the output voltage value reaches a voltage value greater than a fifth peak. In the second

resonance voltage $V_{res}$, the charge capacitor $C_c$ is further charged with electric charge by the second and third damped oscillation peaks, and as a result, the output voltage value $V_{pho}$ further rises until the output voltage value reaches a voltage value greater than the fourth peak. In the third resonance voltage $V_{res}$, the charge capacitor $C_c$ is further charged with electric charge by the second and third damped oscillation peaks, and as a result, the output voltage value $V_{pho}$ further rises until the output voltage value reaches a voltage value greater than the third peak. In the fourth to sixth resonance voltages $V_{res}$, the charge capacitor $C_c$ is further charged with electric charge by the second damped oscillation peak, and as a result, the output voltage value $V_{pho}$ rises until the output voltage value finally reaches a voltage value equal to the peak voltage of the second peak, and the peak voltage value of the second peak that is the target peak is acquired and held as the output voltage value $V_{pho}$.

As such, in the peak hold device 100 according to the embodiment, the charge capacitor $C_c$ is charged with electric charge not only by the target peak as the target of the peak hold process, but also by other peaks included in the resonance voltage $V_{res}$ having the damped oscillation waveform. Accordingly, by utilizing the other peaks, the output voltage value $V_{pho}$ can be raised more quickly to the peak voltage value of the target peak.

In step S28, the output voltage value $V_{pho}$ is read. The output voltage value $V_{pho}$ acquired and held in steps S10 to S26 is read.

In step S30, it is determined whether to perform peak hold for the next peak. When the peak hold process is to be performed for the next peak, the process proceeds to step S34, and when the peak hold process is to end, the process proceeds to step S32.

In step S32, the switch $SW_{dch}$ is turned on, the charge capacitor $C_c$ is discharged to the reset state, and the peak hold process ends. In step S34, the next peak is set as a target peak, and the peak hold process for the set target peak starts. Here, it is preferable to turn on the switch $SW_{dch}$, discharge the charge capacitor $C_c$ to the reset state, and then turn off the switch $SW_{dch}$. In step S36, the count value is reset to 0, and the process is repeated from step S12.

In the resonance voltage $V_{res}$ having the damped oscillation waveform, by changing the target peak from a later peak having a lower peak voltage value to an earlier peak having a higher peak voltage value, it is not necessary to turn on the switch $SW_{dch}$ to discharge the charge capacitor $C_c$ after acquiring and holding the peak voltage value of each peak as the output voltage value $V_{pho}$. That is, by acquiring, holding, and reading the later peak having a lower peak voltage value as the output voltage value $V_{pho}$, and then setting the earlier peak having a higher peak voltage value as the next target peak, it is possible to further charge the charge capacitor $C_c$ with the electric charge to be equal to the peak voltage value of the next target peak, and acquire and hold the charge as the output voltage value $V_{pho}$ without discharging the charge accumulated in the charge capacitor $C_c$ until then.

As described above, the peak hold process for the resonance voltage $V_{res}$ having the damped oscillation waveform can be implemented by the peak hold device 100 according to the embodiment. In the peak hold device 100, by adopting an integrating type in which charging of the charge capacitor $C_c$ with electric charge is performed a plurality of times, the amount of following per cycle becomes smaller but an accuracy of following the peak voltage value increases. Therefore, even in a resonance voltage $V_{res}$ having a highfrequency damped oscillation waveform exceeding 10 kHz for which it is difficult to follow the peak by a single peak hold process, the peak voltage value can be acquired and held as the output voltage value $V_{pho}$ with higher accuracy.

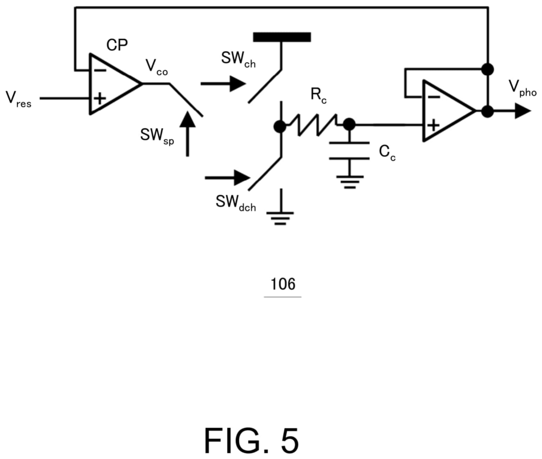

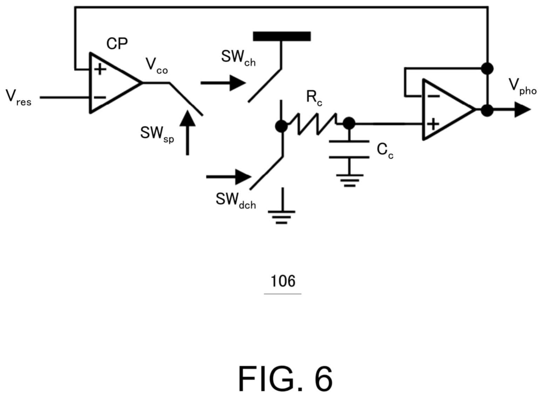

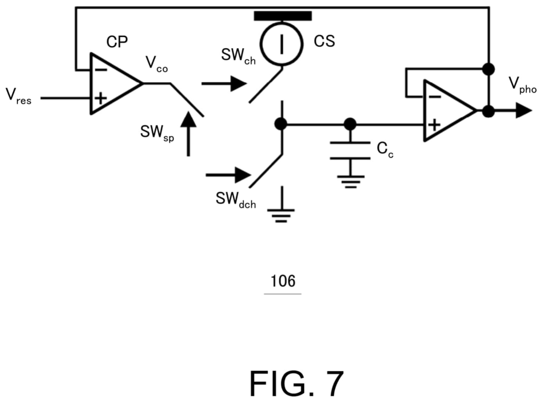

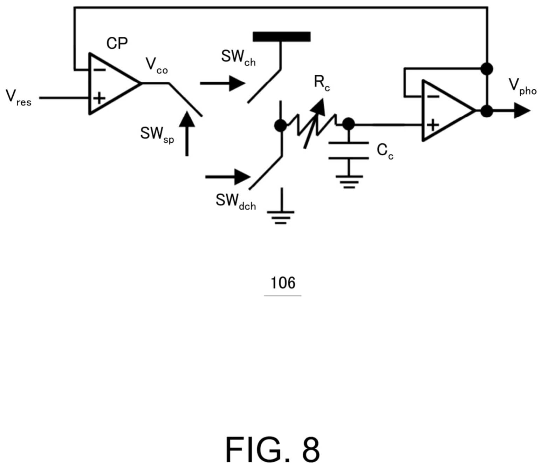

FIGS. 5 to 8 illustrate examples of the peak hold circuit 106. FIG. 5 illustrates a non-inverting type peak hold circuit including the comparator CP applied to the peak hold device 100 illustrated in FIG. 1. The non-inverting type peak hold circuit is used when a peak voltage value of a positive peak (maximum peak) of the resonance voltage $V_{res}$ is to be acquired. FIG. 6 illustrates an inverting type peak hold circuit including the comparator CP. The inverting type peak hold circuit is used when a peak voltage value of a negative peak (minimum peak) of the resonance voltage $V_{res}$ is to be acquired. FIG. 7 illustrates a non-inverting type peak hold circuit in which a voltage source via the resistor $R_c$ is changed to a constant current source CS in the charge supply circuit regarding the charge capacitor $C_c$. FIG. 8 illustrates a non-inverting type peak hold circuit in which the resistor $R_c$ is changed to a variable resistor in the charge supply circuit regarding the charge capacitor $C_c$. By providing the variable resistor as the resistor $R_c$, the time constant for charging the charge capacitor $C_c$ is variable, thereby enabling the peak voltage value to be acquired at a higher speed and with higher accuracy. The configurations of FIGS. 7 and 8 may also be applicable to an inverting type peak hold circuit including the comparator CP.

[Battery Impedance Calculation Method]

Hereinafter, a method for calculating an internal impedance of the battery BAT will be described.

A resonance voltage $V_{res}(t)$ is expressed by Mathematical Expressions (1) to (6). Here, a voltage of the battery BAT is $V_{bat}$, an internal capacitance of the battery BAT is $C_{bat}$, an internal inductance of the battery BAT is $L_{bat}$, and an internal resistance of the battery BAT is $R_{bat}$, a resonance capacitance of the resonance circuit 102 is $C_{res}$, resonance inductances of the resonance circuit 102 are $L_{res}$ (primary side) and $L_{sec}$ (secondary side), a mutual inductance of the resonance inductance $L_{res}$ (primary side) and the resonance inductance $L_{sec}$ (secondary side) is M, a resonance resistance of the resonance circuit 102 is $R_{res}$, a resonance angular frequency of the resonance circuit 102 is $\omega_0$, a series combined inductance of the resonance inductance $L_{res}$ (primary side) and the internal inductance $L_{bat}$ is Ls, a series combined capacitance of the resonance capacitance $C_{res}$ and the internal capacitance $C_{bat}$ is Cs, an elapsed time from a resonance start time is $t_n$, a damping rate of a damped resonance voltage is $\alpha$, and a phase difference of the damped resonance voltage is $\beta$.

[Mathematical Expression 1]

$$V_{res}(t) = \frac{MV_{bat}}{L_s}\sqrt{\frac{\alpha^2}{\omega_0^2}+1}\,e^{-\alpha t}\cos(\omega_0 t + \beta) \qquad \cdots \ (1)$$

[Mathematical Expression 2]

$$\fallingdotseq C_{res}C_s = \frac{C_{res}+C_{bat}}{C_{res}+C_{bat}} \fallingdotseq C_{res} \qquad \cdots \ (2)$$

[Mathematical Expression 3]

$$L_s = L_{res} + L_{bat} \cdots \ (3)$$

[Mathematical Expression 4]

$$\alpha = \frac{R_{bat}}{2L_s} + \frac{1}{2C_{res}R_{res}} \cdots \ (4)$$

[Mathematical Expression 5]

$$\omega_0 = \sqrt{\frac{R_{res}+R_{bat}}{R_{res}L_sC_s}-\alpha^2} \qquad \cdots \ (5)$$

[Mathematical Expression 6]

$$\beta = \arcsin\left(\frac{e^{-\alpha t}L_s}{\sqrt{\dfrac{\alpha^2}{\omega_0^2}+1}}\right) \qquad \cdots \ (6)$$

A resonance voltage $V_{res}(t_n)$ at an N-th resonance point is expressed by Mathematical Expression (7).

[Mathematical Expression 7]

$$V_{res}(t_n) = \frac{MV_{bat}}{L_s} \sqrt{\frac{\alpha^2}{\omega_0^2} + 1}\, e^{-\alpha t_n}$$

$$\cdots (7)$$

From any n = n1, n2 (n1 > n2), the damping rate $\alpha$ is expressed by Mathematical Expression (8).
[Mathematical Expression 8]

$$\alpha = \frac{1}{t_{n2} - t_{n1}} \ln \frac{|V_{res}(t_{n1})|}{|V_{res}(t_{n2})|} \quad \cdots (8)$$

When the resonance resistance $R_{res}$ of the resonance circuit 102 is sufficiently greater than the internal resistance $R_{bat}$ of the battery BAT ($R_{res} \gg R_{bat}$), the resonance angular frequency $\omega_0$ is expressed by Mathematical Expression (9).
[Mathematical Expression 9]

$$\omega_0 = \sqrt{\frac{1}{L_s C_s} - \alpha^2} \quad \cdots (9)$$

A real impedance $R_{bat}$ and an imaginary impedance $L_{bat}$ of the battery BAT can be obtained by Mathematical Expressions (10) and (11). Note that the internal capacitance $C_{bat}$ can be ignored, since the internal capacitance $C_{bat}$ of the battery BAT is very large.
[Mathematical Expression 10]

$$R_{bat} = 2(L_{res} + L_{bat})\left\{\alpha - \frac{1}{2C_{res}R_{res}}\right\} \quad \cdots (10)$$

[Mathematical Expression 11]

$$L_{bat} = \frac{1}{C_s} \frac{1}{\omega_0^2 + \alpha^2} - L_{res} \quad \cdots (11)$$

As described above, the real impedance $R_{bat}$ and the imaginary impedance $L_{bat}$ of the battery BAT can be calculated based on a peak voltage value of a maximum peak or a minimum peak of the resonance voltage $V_{res}(t)$ acquired in the peak hold device 100.

[Method For Detecting Deposition Amount of Lithium Inside Battery]

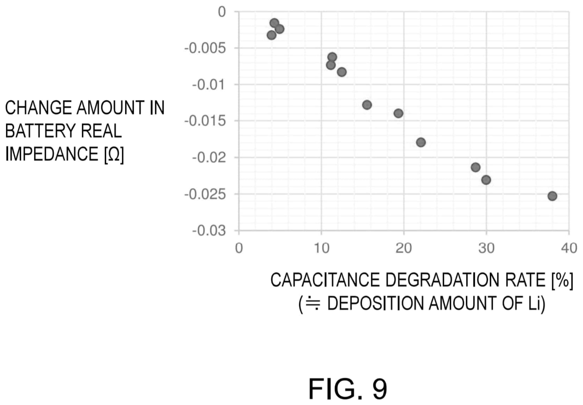

FIG. 9 shows a change amount in a real impedance (at 1 MHz) of the battery BAT regarding a deposition amount of lithium (Li) when the battery BAT is a lithium-ion battery. A degradation test in which commercially available cylindrical lithium-ion batteries were subjected to repeated high-rate charging at low temperatures to induce lithium (Li) deposition was performed and the results are illustrated.

As illustrated in FIG. 9, the deposition amount of lithium (Li) shows a linear changing relationship with the change amount in the real impedance of the battery BAT, and the deposition amount of lithium (Li) in the battery BAT can be estimated by: Deposition amount of lithium = Change amount in real impedance of battery BAT × Coefficient.

[Method for Estimating Battery Internal Temperature]

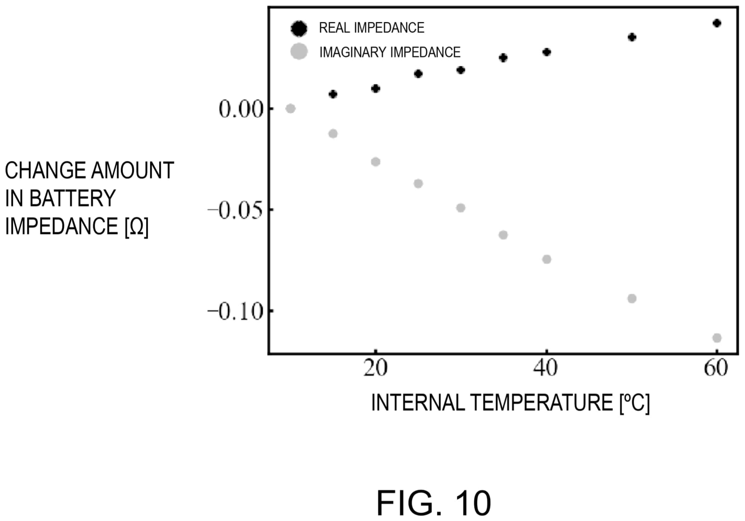

FIG. 10 illustrates change amounts in the real impedance and the imaginary impedance (at 1 MHz) of the battery BAT with respect to an internal temperature of the battery BAT. The change amounts in the real impedance and the imaginary impedance of the battery BAT show a linear changing relationship with the internal temperature of the battery BAT, and the internal temperature of the battery BAT can be estimated by: Internal temperature of battery BAT = Coefficient × Change amount of impedance + Reference temperature.

[Configuration of Present Disclosure]

[Configuration 1]

A peak hold device, in which

the peak hold device acquires a peak value of any maximum peak or minimum peak included in a damped oscillation waveform, and
the peak hold device uses the maximum peak or the minimum peak as a target peak from which to acquire the peak value, and for a plurality of damped oscillation waveforms, repeats a process of starting to hold a damped oscillation waveform value at a time before the target peak, and ceasing to hold the damped oscillation waveform value at a time after the target peak.

[Configuration 2]

The peak hold device according to Configuration 1, in which, after starting to hold the damped oscillation waveform value at the time before the target peak, a value of a damped oscillation waveform including a maximum peak or a minimum peak other than the target peak is held.

[Configuration 3]

The peak hold device according to Configuration 1 or 2, further including

a peak hold circuit including
a charging circuit including a capacitor,
a switch for starting or ceasing charging of the capacitor, and
a comparator, in which
the comparator compares an output voltage value of the peak hold circuit with a voltage value of the damped oscillation waveform and outputs a comparison result, and
the switch is turned on according to the comparison result to start charging of the capacitor at the time before the target peak, and the switch is turned off according to the comparison result to cease charging of the capacitor at the time after the target peak.

[Configuration 4]

The peak hold device according to Configuration 3, in which the charging circuit includes a resistor between a charging part supplying power to the capacitor and the capacitor.

[Configuration 5]

The peak hold device according to Configuration 4, in which

the resistor is a variable resistor, and
charging of the capacitor is controlled by changing a resistance value of the variable resistor in response to a change in the output voltage of the peak hold circuit.

[Configuration 6]

An impedance measurement device measuring a real impedance and an imaginary impedance of a battery using the peak value acquired by the peak hold device according to any one of Configurations 1 to 5.

[Configuration 7]

A metal deposition detection device estimating a deposition amount of metal in a lithium-ion battery from a decrease in the real impedance measured by the impedance measurement device according to Configuration 6.

[Configuration 8]

A battery internal temperature estimation device estimating an internal temperature of the battery from a change amount of at least one of the real impedance and the imaginary impedance measured by the impedance measurement device according to Configuration 6.

REFERENCE SIGNS LIST

    100: peak hold device
    102: resonance circuit
    104: differential single conversion circuit
    106: peak hold circuit
    BAT: battery
    CP: comparator
    CS: constant current source
    SW$_{ch}$: switch
    SW$_{dch}$: switch
    SW$_{res}$: switch
    SW$_{sp}$: switch


**Claims**

1. A peak hold device, wherein

    the peak hold device acquires a peak value of any maximum peak or minimum peak included in a damped oscillation waveform, and
    the peak hold device uses the maximum peak or the minimum peak as a target peak from which to acquire the peak value, and for a plurality of damped oscillation waveforms, repeats a process of starting to hold a damped oscillation waveform value at a time before the target peak, and ceasing to hold the damped oscillation waveform value at a time after the target peak.

2. The peak hold device according to claim 1, wherein, after starting to hold the damped oscillation waveform value at the time before the target peak, a value of a damped oscillation waveform including a maximum peak or a minimum peak other than the target peak is held.

3. The peak hold device according to claim 1, further comprising:

    a peak hold circuit including
    a charging circuit including a capacitor,
    a switch for starting or ceasing to charge the capacitor, and
    a comparator, wherein
    the comparator compares an output voltage value of the peak hold circuit with a voltage value of the damped oscillation waveform and outputs a comparison result, and
    the switch is turned on according to the comparison result to start charging of the capacitor at the time before the target peak, and the switch is turned off according to the comparison result to cease charging of the capacitor at the time after the target peak.

4. The peak hold device according to claim 3, wherein the charging circuit includes a resistor between a charging part supplying power to the capacitor and the capacitor.

5. The peak hold device according to claim 4, wherein

the resistor is a variable resistor, and
charging of the capacitor is controlled by changing a resistance value of the variable resistor in response to a change in the output voltage of the peak hold circuit.

6. An impedance measurement device measuring a real impedance and an imaginary impedance of a battery using the peak value acquired by the peak hold device according to claim 1.

7. A metal deposition detection device estimating a deposition amount of metal in a lithium-ion battery from a decrease in the real impedance measured by the impedance measurement device according to claim 6.

8. A battery internal temperature estimation device estimating an internal temperature of the battery from a change amount of at least one of the real impedance and the imaginary impedance measured by the impedance measurement device according to claim 6.

FIG. 1

100

EP 4 730 658 A1

FIG. 2

12

FIG. 3

FIG. 4

106

FIG. 5

106

FIG. 6

FIG. 7

106

FIG. 8

EP 4 730 658 A1

CHANGE AMOUNT IN
BATTERY REAL
IMPEDANCE [Ω]

CAPACITANCE DEGRADATION RATE [%]
(≒ DEPOSITION AMOUNT OF Li)

FIG. 9

CHANGE AMOUNT IN BATTERY IMPEDANCE [Ω]

INTERNAL TEMPERATURE [ºC]

FIG. 10

EP 4 730 658 A1

## INTERNATIONAL SEARCH REPORT

| International application No. |
|---|
| **PCT/JP2024/021023** |

**A. CLASSIFICATION OF SUBJECT MATTER**

*H03M 1/12*(2006.01)i; *G01R 31/388*(2019.01)i; *H01M 10/48*(2006.01)i; *H02J 7/00*(2006.01)i; *H02J 7/04*(2006.01)i; *H02J 7/10*(2006.01)i

FI: H03M1/12 A; G01R31/388; H01M10/48 P; H01M10/48 301; H02J7/00 Q; H02J7/04 L; H02J7/10 C; H02J7/10 N

According to International Patent Classification (IPC) or to both national classification and IPC

**B. FIELDS SEARCHED**

Minimum documentation searched (classification system followed by classification symbols)

H03M1/12; G01R31/388; H01M10/48; H02J7/00; H02J7/04; H02J7/10

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2017-67641 A (KABUSHIKI KAISHA TOSHIBA) 06 April 2017 (2017-04-06) paragraphs [0009]-[0035], [0054]-[0069], fig. 1-3B, 10-11 | 1-3 |
| Y | | 4-5 |
| Y | CD-ROM of the specification and drawings annexed to the request of Japanese Utility Model Application No. 63047/1993 (Laid-open No. 29479/1995) (ADVANTEST CORP.) 02 June 1995 (1995-06-01), paragraph [0012], fig. 2 | 4-5 |
| Y | WO 2011/148467 A1 (FUJITSU LIMITED) 01 December 2011 (2011-12-01) paragraph [0052], fig. 13 | 4-5 |
| A | JP 2002-90396 A (SONY CORPORATION) 27 March 2002 (2002-03-27) entire text, all drawings | 1-5 |

☐ Further documents are listed in the continuation of Box C.    ☑ See patent family annex.

| | | |
|---|---|---|
| * | Special categories of cited documents: | |
| "A" | document defining the general state of the art which is not considered to be of particular relevance | |
| "D" | document cited by the applicant in the international application | |
| "E" | earlier application or patent but published on or after the international filing date | |
| "L" | document which may throw doubts on priority claim(s) or which is cited to establish the publication date of another citation or other special reason (as specified) | |
| "O" | document referring to an oral disclosure, use, exhibition or other means | |
| "P" | document published prior to the international filing date but later than the priority date claimed | |

"T" later document published after the international filing date or priority date and not in conflict with the application but cited to understand the principle or theory underlying the invention

"X" document of particular relevance; the claimed invention cannot be considered novel or cannot be considered to involve an inventive step when the document is taken alone

"Y" document of particular relevance; the claimed invention cannot be considered to involve an inventive step when the document is combined with one or more other such documents, such combination being obvious to a person skilled in the art

"&" document member of the same patent family

| Date of the actual completion of the international search | Date of mailing of the international search report |
|---|---|
| **30 July 2024** | **13 August 2024** |

| Name and mailing address of the ISA/JP | Authorized officer |
|---|---|
| **Japan Patent Office (ISA/JP)** 3-4-3 Kasumigaseki, Chiyoda-ku, Tokyo 100-8915 Japan | |
| | Telephone No. |

Form PCT/ISA/210 (second sheet) (July 2022)

## INTERNATIONAL SEARCH REPORT

| International application No. |
|---|
| **PCT/JP2024/021023** |

**Box No. II**    **Observations where certain claims were found unsearchable (Continuation of item 2 of first sheet)**

This international search report has not been established in respect of certain claims under Article 17(2)(a) for the following reasons:

1. ☐ Claims Nos.:
because they relate to subject matter not required to be searched by this Authority, namely:

2. ☑ Claims Nos.: **6-8**
because they relate to parts of the international application that do not comply with the prescribed requirements to such an extent that no meaningful international search can be carried out, specifically:

In the inventions in claims 6-8, no concrete configuration is specified, and it is not possible to understand the technical significance of the matters specifying the inventions. Moreover, the category to which the inventions in claims 6-8 belong is not even specified, and said inventions cannot be said to belong to any particular category. Therefore, even by referring to the disclosures in the description and the drawings as well as common technical knowledge at the time of filing, it is not possible to grasp what kind of inventions the abovementioned claims are intended to recite, and the inventions in claims 6-8 are highly unclear. Accordingly, claims 6-8 do not satisfy the requirement of clarity stipulated in PCT Article 6.
Furthermore, no amendment can be foreseen that would enable a meaningful search.
Thus, as it is not possible to carry out a meaningful search with respect to claims 6-8, a search was not carried out.

3. ☐ Claims Nos.:
because they are dependent claims and are not drafted in accordance with the second and third sentences of Rule 6.4(a).

Form PCT/ISA/210 (continuation of first sheet) (July 2022)

**INTERNATIONAL SEARCH REPORT**
Information on patent family members

International application No.

**PCT/JP2024/021023**

| Patent document cited in search report | | | Publication date (day/month/year) | Patent family member(s) | Publication date (day/month/year) |
|---|---|---|---|---|---|
| JP | 2017-67641 | A | 06 April 2017 | US 2017/0086702 A1 paragraphs [0027]-[0053], [0072]-[0087], fig. 1-3B, 10-11 | |
| JP | 7-29479 | U1 | 02 June 1995 | (Family: none) | |
| WO | 2011/148467 | A1 | 01 December 2011 | US 2013/0063196 A1 paragraphs [0076]-[0077], fig. 13 | |
| JP | 2002-90396 | A | 27 March 2002 | (Family: none) | |

Form PCT/ISA/210 (patent family annex) (July 2022)